# EUROPEAN PATENT APPLICATION

(11) **EP 1 956 646 A1**
(43) Date of publication of application: **13.08.2008**
(21) Application number: 06822756.0
(22) Date of filing: 01.11.2006
(51) Int. Cl.: H01L 21/56, B29C 45/14, B29C 45/17

(54) **RESIN-SEALED MOLDING APPARATUS WITH SEALING MEANS, AND METHOD OF DISMOUNTING CONSTITUENT PART OF DIE ASSEMBLY FITTED THEREIN**

(30) Priority: 29.11.2005 JP 2005343742
(71) Applicant: Towa Corporation, Kyoto 601-8105 (JP)
(72) Inventor: IJIRI, Kazuhiro, Kyoto-shi, Kyoto 601-8105 (JP)
(74) Representative: Forsyth, Helen Jane
(86) International application number: PCT/JP2006/321827
(87) International publication number: WO 2007/063673

(57) **Abstract**

A resin-sealing and molding apparatus furnished with sealing mechanism. The sealing mechanism includes upper-die-side ambient air shutoff member (11) fixed to upper-die-side mount base board (15) so as to surround the lateral side of upper die (1) and lower-die-side ambient air shutoff member (12) fixed to lower-die-side mount base board (16) so as to surround the lateral side of lower die (2). The upper-die-side ambient air shutoff member (11) is fixed to the upper-die-side mount base board (15) by means of upper-die-side fixing tool (24). The lower-die-side ambient air shutoff member (12) is fixed to the lower-die-side mount base board (16) by means of lower-die-side fixing tool (27). The upper-die-side ambient air shutoff member (11) and the upper-die-side mount base board (15) are pivotably connected by means of axis member (22). Only by dismounting of the lower-die-side fixing tool (27) from the lower-die-side mount base board (16) and the lower-die-side ambient air shutoff member (12), there can be realized the state in which the lower-die-side ambient air shutoff member (12) can be completely dismounted from the lower-die-side mount base board (16).

## Description

### TECHNICAL FIELD

The present invention relates to an improvement of sealing mechanism provided on an apparatus sealing and molding an electronic component such as an IC (Integration Circuit) with a die assembly and a method of dismounting a constituent part of the die assembly fitted in this apparatus.

### BACKGROUND ART

A resin-sealing and molding apparatus (hereinafter simply referred to as "apparatus" as well) furnished with a die assembly having an upper die and a lower die is employed in general. In this apparatus, air containing moisture such as the so-called damp remains in the internal space of the die assembly. In resin-sealing and molding, therefore, the residual air is mixed into a melted resin material. Consequently, voids (air bubbles) are formed in the resin-sealing and molding and on the surface thereof.

A sealing mechanism and a decompression mechanism are provided in order to prevent the aforementioned formation of voids. The sealing mechanism is employed for converting the internal space of the die assembly to a space (hereinafter referred to as "ambient air shutoff space") shut off from the ambient air. The decompression mechanism is employed for ejecting the air etc. remaining in the internal space of the die assembly by forced suction. The ambient air shutoff space and the decompression mechanism communicate with each other through a vacuum passage.

According to the aforementioned conventional resin-sealing and molding apparatus, an electronic component provided on a lead frame (board) set on first molding surfaces of the upper and lower molds is sealed while the degree of vacuum in the internal space of the die assembly is set to a desired value (Japanese Patent No. 3566426 (refer to Japanese Patent Laying-Open No. 9-123205, for example)).

The conventional sealing mechanism includes an upper-die-side ambient air shutoff member so provided as to surround the four side surfaces of the upper die and a lower-die-side ambient air shutoff member so provided as to surround the four side surfaces of the upper die, in order to shut off the internal space of the die assembly from the ambient air. Thus, the upper-die-side ambient air shutoff member and the lower-die-side ambient air shutoff member come into contact with each other when the upper and lower dies are closed, for forming the aforementioned ambient air shutoff space.

The upper-die-side ambient air shutoff member pivot about the pivot axis of a hinge connecting an upper-die-side mount base board and the upper-die-side ambient air shutoff member with each other. Thus, an upper-die-side opening is formed between the pivoting upper-die-side ambient air shutoff member and the upper-die-side mount base board mounted with the upper die. In this state, an upper die chaser unit constituting the molding surface of the upper die is mounted on an upper die base or dismounted from the upper die chaser unit through the upper-die-side opening.

On the other hand, the lower-die-side ambient air shutoff member pivots about the axis of another hinge connecting a lower-die-side mount base board and the lower-die-side ambient air shutoff member with each other. Thus, a lower-die-side opening is formed between the pivoting lower-die-side ambient air shutoff member and the lower-die-side mount base board mounted with the lower die. In this state, a lower die chaser unit constituting the molding surface of the lower die is mounted on a lower die base or dismounted from the lower die base through the lower-die-side opening.

According to the aforementioned conventional resin-sealing and molding apparatus, further, the upper-die-side ambient air shutoff member and the lower-die-side ambient air shutoff member can retreat to positions not hindering a cleaning mechanism inserted into the space between the upper and lower dies when the respective molding surfaces of the upper and lower dies are cleaned.

While the die assembly (upper and lower dies) stored in the aforementioned apparatus is frequently exchanged, the respective ones of the upper-die-side ambient air shutoff member and the lower-die-side ambient air shutoff member so pivot as to form the openings for mounting and dismounting the die assembly as described above, leading to high efficiency of the operation for exchanging the die assembly.

In the aforementioned apparatus, hinges are provided on the back surface of the die assembly while a spring lock is provided on the front surface, in order to fix the lower-die-side ambient air shutoff member and the lower-die-side mount base board to each other. The spring lock is so employed as to fix the upper-die-side ambient air shutoff member and the upper-die-side mount base board to each other as well. The aforementioned fixing method using the spring lock and the hinges contributes to improvement of the operation for exchanging the die assembly.
Patent Document 1: Japanese Patent No. 3566426 (Japanese Patent Laying-Open No. 9-123205)

### DISCLOSURE OF THE INVENTION

### PROBLEMS TO BE SOLVED BY THE INVENTION

The aforementioned conventional sealing mechanism, designed with importance attached to the improvement of the operation for exchanging the die assembly as described above, has the following problems:
According to the conventional sealing mechanism, stable airtightness can be maintained when resin-sealing and molding is started. If the resin-sealing and molding is repeated, however, residual resin waste remains in the die assembly. This resin waste does not remain in the upper die but naturally drops onto the lower die. Therefore, the resin waste remaining in the die assembly is deposited in the clearance between the lower-die-side ambient air shutoff member and the lower-die-side mount base board. The resin waste deposited in this clearance reduces the life of a sealing member such as an O-ring and prompts deterioration and damage of the sealing member. Consequently, the degree of vacuum in the internal space of the die assembly cannot be kept at the desired value.

If the degree of vacuum in the internal space of the die assembly cannot be kept at the desired value, manual cleaning must be performed in order to remove the resin waste deposited in the aforementioned clearance. However, the lower-die-side ambient air shutoff member and the lower-die-side mount base board are connected with each other through the hinge, and hence it is difficult to completely remove the resin waste from the clearance between the lower-die-side ambient air shutoff member and the lower-die-side mount base board.

In short, reduction of airtightness in the internal space of the die assembly cannot be prevented according to the conventional resin-sealing and molding apparatus, although the efficiency of the operation for exchanging the die assembly can be improved.

The present invention has been proposed in consideration of the aforementioned problems, and an object thereof is to provide a resin-sealing and molding apparatus having sealing mechanism capable of preventing reduction of airtightness in the internal space of a die assembly without reducing the efficiency of an operation for exchanging the die assembly and a method of dismounting a constituent part of the die assembly fitted in this apparatus.

### MEANS FOR SOLVING THE PROBLEMS

The resin-sealing and molding apparatus according to the present invention comprises a die assembly having an upper die and a lower die opposed to the upper die, an upper-die-side mount base board mounted with the upper die, a lower-die-side mount base board mounted with the lower die and sealing mechanism for shutting off the internal space of the die assembly from the ambient air.

The sealing mechanism includes an upper-die-side ambient air shutoff member so mounted on the upper-die-side mount base board as to surround the lateral side of the upper die and a lower-die-side ambient air shutoff member so mounted on the lower-die-side mount base board as to surround the lateral side of the upper die. The sealing mechanism also includes an upper-die-side fixing tool fixing the upper-die-side ambient air shutoff member to the upper-die-side mount base board, a lower-die-side fixing tool fixing the lower-die-side ambient air shutoff member to the lower-die-side mount base board and an axis member pivotably connecting the upper-die-side ambient air shutoff member and the upper-die-side mount base board with each other.

Further, the lower-die-side ambient air shutoff member is rendered completely dismountable from the lower-die-side mount base board by simply dismounting the lower-die-side fixing tool from the lower-die-side mount base board and the lower-die-side ambient air shutoff member.

The sealing mechanism may further include a pivot limiting member limiting the range of pivot of the upper-die-side ambient air shutoff member.

The sealing mechanism may further includes an upper-die-side sealing member sealing a clearance between the upper-die-side ambient air shutoff member and the upper-die-side mount base board, a lower-die-side sealing member sealing a clearance between the lower-die-side ambient air shutoff member and the lower-die-side mount base board and an intermediate sealing member sealing a clearance between the upper-die-side ambient air shutoff member and the lower-die-side ambient air shutoff member.

The sealing mechanism may further include a locking portion for fixing the upper-die-side mount base board and the upper-die-side ambient air shutoff member to each other.

The method of dismounting a constituent part of a die assembly according to the present invention is applied to a resin-sealing and molding apparatus.

The aforementioned resin-sealing and molding apparatus comprises a die assembly having an upper die and a lower die opposed to the upper die, an upper-die-side mount base board mounted with the upper die, a lower-die-side mount base board mounted with the lower die and sealing mechanism for shutting off the internal space of the die assembly from the ambient air.

The aforementioned sealing mechanism includes an upper-die-side ambient air shutoff member so mounted on the upper-die-side mount base board as to surround the lateral side of the upper die, a lower-die-side ambient air shutoff member so mounted on the lower-die-side mount base board as to surround the lateral side of the lower die, an upper-die-side fixing tool fixing the upper-die-side ambient air shutoff member to the upper-die-side mount base board, a lower-die-side fixing tool fixing the lower-die-side ambient air shutoff member to the lower-die-side mount base board and an axis member pivotably connecting the upper-die-side ambient air shutoff member and the upper-die-side mount base board with each other.

In the method of dismounting a constituent part of a die assembly according to the present invention, the upper-die-side fixing tool is first dismounted from the upper-die-side mount base board and the upper-die-side ambient air shutoff member. Then, an opening is formed between the upper-die-side ambient air shutoff member and the upper-die-side mount base board by pivoting the upper-die-side ambient air shutoff member about the axis member serving as a pivoting axis. Thereafter at least a part of the upper die is dismounted from the upper-die-side mount base board through the opening. Then, the lower-die-side fixing tool is dismounted from the lower-die-side mount base board and the lower-die-side ambient air shutoff member. Thereafter the lower-die-side ambient air shutoff member is dismounted from the lower-die-side mount base board. Then, at least a part of the lower die is dismounted from the lower-die-side mount base board.

In the aforementioned step of dismounting the lower-die-side ambient air shutoff member, the lower-die-side ambient air shutoff member may be dismounted with a jig

### EFFECTS OF THE INVENTION

According to the present invention, a resin-sealing and molding apparatus having sealing mechanism capable of preventing reduction of airtightness in the internal space of a die assembly without reducing the efficiency of an operation for exchanging the die assembly and a method of dismounting a constituent part of the die assembly fitted in this apparatus can be provided.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a side elevational view schematically showing a sealing mechanism of a resin-sealing and molding apparatus according to an embodiment.
Fig. 2 is a front elevational view schematically showing the sealing mechanism of the resin-sealing and molding apparatus according to the embodiment.
Fig. 3 is a side elevational view for illustrating a method of exchanging an upper die chaser unit of the resin-sealing and molding apparatus according to the embodiment.
Fig. 4 is a side elevational view for illustrating the method of exchanging the upper die chaser unit of the resin-sealing and molding apparatus according to the embodiment.
Fig. 5 is a front elevational view for illustrating a method of exchanging a lower die chaser unit of the resin-sealing and molding apparatus according to the embodiment.
Fig. 6 is a front elevational view for illustrating the method of exchanging the lower die chaser unit of the resin-sealing and molding apparatus according to the embodiment.
Fig. 7 is a front elevational view for illustrating the method of exchanging the lower die chaser unit of the resin-sealing and molding apparatus according to the embodiment.
Fig. 8 is a front elevational view for illustrating the method of exchanging the lower die chaser unit of the resin-sealing and molding apparatus according to the embodiment.

### DESCRIPTION OF THE REFERENCE SIGNS

1 upper die, 2 lower die, 3 upper die chaser unit, 4 upper die base, 5 dovetail groove, 6 fixed block, 7 lower die chaser unit, 8 lower die base, 9 dovetail portion, 10 ambient air shutoff space, 11 upper-die-side ambient air shutoff member, 11a pivoting lower-die-side ambient air shutoff member, 12 lower-die-side ambient air shutoff member, 13 upper-die-side sealing member, 14 lower-die-side sealing member, 15 upper-die-side mount base board, 16 lower-die-side mount base board, 17 hollow sealing member, 17a swollen hollow sealing member, 18 pressurization mechanism, 19 pressurization path, 20 decompression mechanism, 21 vacuum path, 22 axis member, 23 pivot limiting member, 24 upper-die-side fixing tool, 24a bolt, 24b locking portion, 25 prevent portion, 26 opening, 27 lower-die-side fixing tool, 27a bolt, 28 upper-die-side receiving hole, 29 lower-die-side receiving hole, 30 first die assembly exchange jig, 31 upper-die-side protrusion, 32 lower-die-side protrusion, 33 through-hole, 34 second die assembly exchange jig, 35 recess, 36 fitting part, 50 tie-bar, 60 transport rail, 61 recess, 100 resin-sealing and molding apparatus, A arrow indicating position of exchange plane.

### BEST MODES FOR CARRYING OUT THE INVENTION

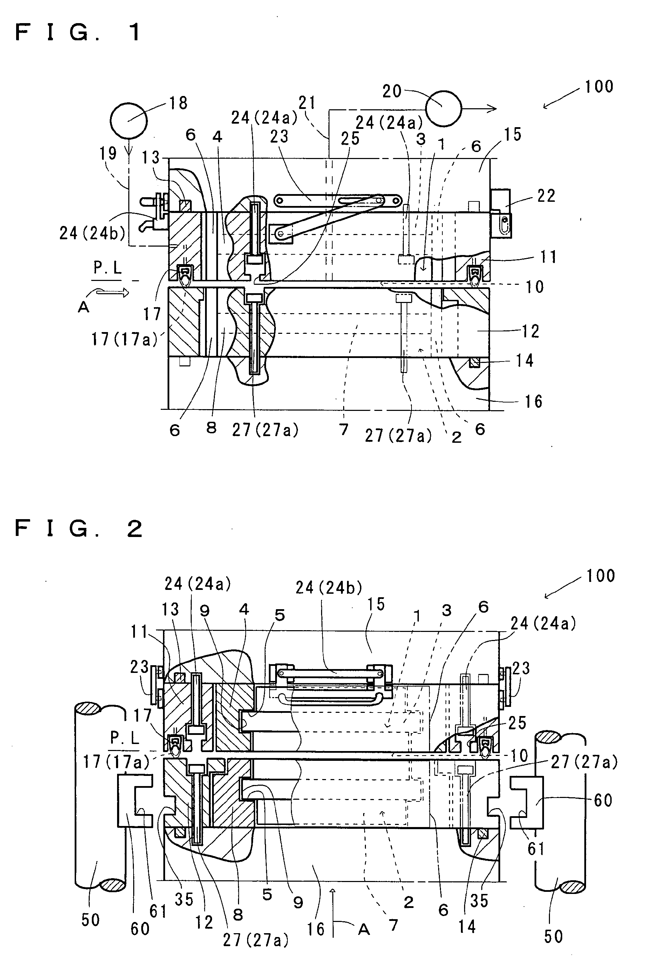

A resin-sealing and molding apparatus according to an embodiment is now described with reference to Figs. 1 to 8. Front elevational views included in Figs. 1 to 8 illustrate the apparatus as viewed along the direction of a path for exchanging a die assembly. Therefore, the forward end of arrow A in the figures denotes a specific plane in the path for extracting and dismounting the die assembly, and this plane is referred to as an exchange plane A.

As shown in Figs. 1 to 8, a resin-sealing and molding apparatus 100 (hereinafter simply referred to as "apparatus 100") according to this embodiment comprises a die assembly. The die assembly has an upper die 1 whose position is fixed and a movable lower die 2 opposed to upper die 1.

Apparatus 100 comprises a basement (not shown) and a necessary number of tiebars 50 vertically extending from the basement, as shown in Figs. 2 and 5 to 8. A fixed member (not shown) is fixed to the upper end of each tie-bar 50. A movable member (not shown) is slidably mounted on each tie-bar 50.

An upper-die-side mount base board 15 is mounted on the fixed member, while a lower-die-side mount base board 16 is mounted on the movable member. Apparatus 100 further comprises transport rails 60. Transport rails 60 are employed for guiding a feeding/extracting mechanism (not shown). The feeding/extracting mechanism feeds a resin material or a base board to the die assembly or extracts the same from the die assembly. The feeding/extracting mechanism also has a function of removing resin waste from molding surfaces, and can advance into the space between upper die 1 and lower die 2 or retreat from this space. The feeding/extracting mechanism may be integrally provided on apparatus 100, or may be separable from apparatus 100.

Apparatus 100 is not restricted to the one having the single die assembly shown in the figures but may have a plurality of die assemblies attachable/detachable respectively.

The structure of the die assembly is not restricted to the dual-die structure having upper die 1 and lower die 2, but the die assembly may alternatively have a triple-die structure having an intermediate die between upper die 1 and lower die 2 or a structure composed of at least three dies.

This die assembly may be a die assembly for transfer molding, or a die assembly for transferless molding (compression molding). The molding surfaces of the die assembly may be covered with mold releasing films.

A wire bonding substrate, a flip chip substrate or a wafer level package such as a wafer substrate is conceivable as a molding (substrate mounted with electronic components, for example) formed by apparatus 100. The substrate may have any shape such as a circular or polygonal shape. Further, the substrate may be any substrate such as a printed circuit board of plastic, ceramic, glass or another material referred to as a metal lead frame or a PC (printed circuit) boat. On the other hand, the resin material employed for sealing/molding may be any resin such as tablet resin, liquid resin, granular resin or powder resin.

Upper die 1 is fixed to upper-die-side mount base board 15 described later. Upper-die-side mount base board 15 is mounted on the fixed member. In other words, upper die 1 is indirectly fixed to the fixed member. Lower die 2 is fixed to lower-die-side mount base board 16 described later. Lower-die-side mount base board 16 is mounted on the movable member. In other words, lower die 2 is indirectly fixed to the movable member.

The movable member is vertically movable through a die opening/closing mechanism (not shown) utilizing a hydraulic mechanism, a pneumatic mechanism or an electric motor provided on the basement. This die opening/closing mechanism can vertically move lower die 2, a lower-die-side ambient air shutoff member 12 described later and lower-die-side mount base board 16 in an integral manner.

When the die opening/closing mechanism moves lower die 2, lower-die-side ambient air shutoff member 12 described later and lower-die-side mount base board 16 upward, therefore, upper die 1 and lower die 2 are closed. Consequently, an upper-die-side ambient air shutoff member 11 and lower-die-side ambient air shutoff member 12 are connected with each other along P.L (parting line).

Upper die 1 has an upper die chaser unit 3 and upper die bases 4. Upper die bases 4 are mounted on the respective ones of both side surfaces of upper die chaser unit 3. Upper die chaser unit 3 and the respective ones of two upper die bases 4 are mountable on and dismountable from each other through a kind of dovetail engagement. Upper die chaser unit 3 is fixed to upper die bases 4 by two fixing blocks 6. Two fixing blocks 6 are fixed to the front and back surfaces of upper die chaser unit 3 and upper die bases 4 respectively.

On the other hand, lower die 2 has a similar structure to upper die 1. In other words, lower die 2 has a lower die chaser unit 7 and lower die bases 8. Lower die bases 8 are mounted on the respective ones of both side surfaces of lower die chaser unit 7. Lower die chaser unit 7 and the respective ones of two lower die bases 8 are mountable on and dismountable from each other through a kind of dovetail engagement. Lower die chaser unit 7 is fixed to lower die bases 8 by two fixing blocks 6. Two fixing blocks 6 are fixed to the front and back surfaces of lower die chaser unit 7 and lower die bases 8 respectively.

As shown in Fig. 2, dovetail portions 9 are provided on the respective ones of upper die chaser unit 3 and lower die chaser unit 7. Further, dovetail grooves 5 corresponding to dovetail portions 9 are provided on the respective ones of upper die bases 4 and lower die bases 8.

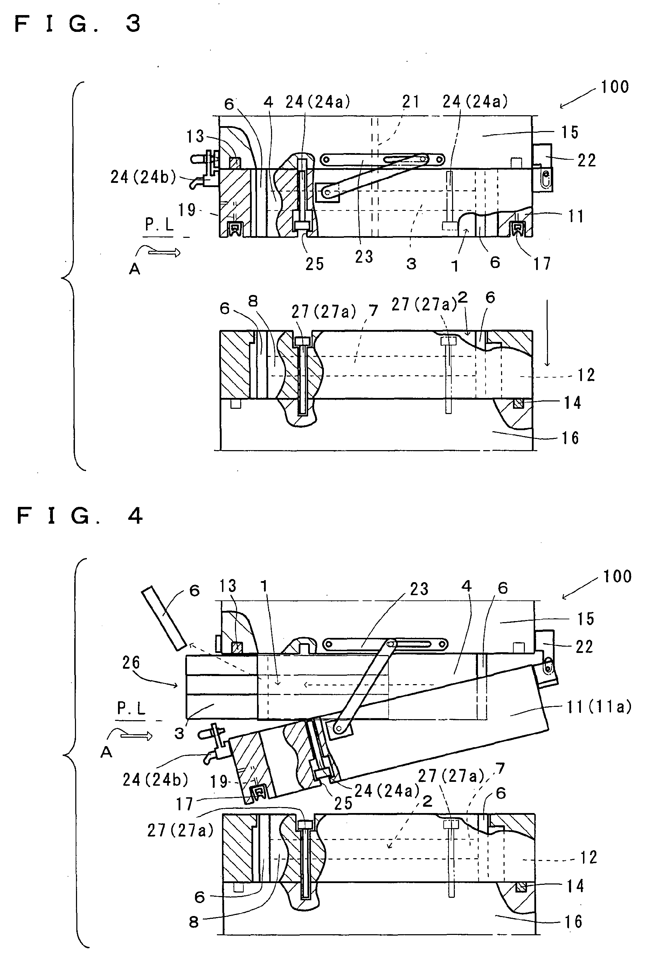

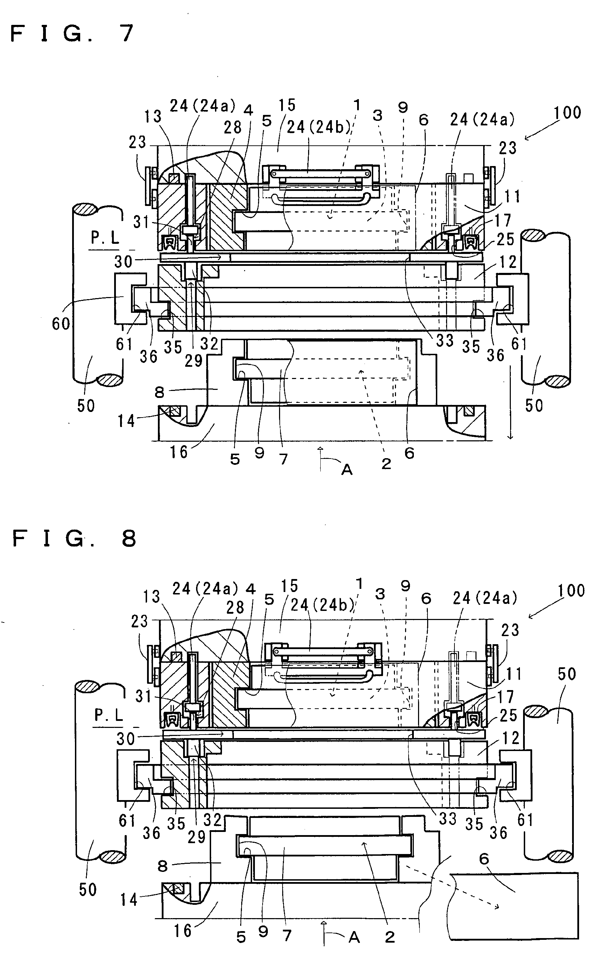

According to the aforementioned structure, upper die chaser unit 3 and lower die chaser unit 7 can be dismounted from upper die bases 4 and lower die bases 8 respectively when the respective ones of upper-die-side fixing blocks 6 and lower-die-side fixing blocks 6 through exchange plane A of the die assembly shown by arrow A. Further, another upper die chaser unit and another lower die chaser unit can be mounted on upper die bases 4 and lower die bases 8 respectively. In other words, upper die chaser unit 3 and lower die chaser unit 7, fixed to upper die bases 4 and lower die bases 8 by fixing blocks 6 respectively when apparatus 100 is in use, can be replaced with another upper die chaser unit and another lower die chaser unit when the same are consumed (see Figs. 4 and 8).

Apparatus 100 is further provided with a sealing mechanism shutting off the internal space of the die assembly from the external space. According to this embodiment, the sealing mechanism includes upper-die-side ambient air shutoff member 11 and lower-die-side ambient air shutoff member 12. However, the sealing mechanism according to the present invention may include elements other than upper-die-side ambient air shutoff member 11 and lower-die-side ambient air shutoff member 12.

Both of upper-die-side ambient air shutoff member 11 and lower-die-side ambient air shutoff member 12 are in the form of cylinders or angular tubes. Upper-die-side ambient air shutoff member 11 surrounds the four side surfaces of upper die 1. Lower-die-side ambient air shutoff member 12 surrounds the four side surfaces of lower die 2. Upper-die-side ambient air shutoff member 11 is mounted on upper-die-side mount base board 15, while lower-die-side ambient air shutoff member 12 is mounted on lower-die-side mount base board 16.

At least one of upper-die-side mount base board 15 and upper-die-side ambient air shutoff member 11 is provided with an upper-die-side sealing member 13 such as an O-ring sealing the clearance between upper-die-side mount base board 15 and upper-die-side ambient air shutoff member 11. Further, at least one of lower-die-side mount base board 16 and lower-die-side ambient air shutoff member 12 is provided with a lower-die-side sealing member 14 such as an O-ring sealing the clearance between lower-die-side mount base board 16 and lower-die-side ambient air shutoff member 12.

When upper die 1 and lower die 2 are closed, the lower surface of upper-die-side ambient air shutoff member 11 and the upper surface of lower-die-side ambient air shutoff member 12 come into contact with each other. At this time, the respective ones of two contact surfaces are located on PL planes. The PL plane (contact surface) of upper-die-side ambient air shutoff member 11 is provided not with an O-ring such as upper-die-side sealing member 13 or lower-die-side sealing member 14 but with a tubular intermediate sealing member 17 of elastic heat-resisting rubber or the like. Intermediate sealing member 17 has a hollow structure. Apparatus 100 further comprises a pressurization mechanism 18 swelling intermediate sealing member 17 by applying pressure to the internal space of intermediate sealing member 17. Intermediate sealing member 17 and pressurization mechanism 18 communicate with each other through a pressurization path 19.

According to the aforementioned structure, intermediate sealing member 17 is converted to a swollen intermediate sealing member 17a when pressurization mechanism 18 swells intermediate sealing member 17, as shown in Figs. 1 and 2. Thus, swollen intermediate sealing member 17a protrudes from the PL plane of upper-die-side ambient air shutoff member 11. Further, swollen intermediate sealing member 17a comes into contact with the molding surface of lower die 2 on the PL plane of lower-die-side ambient air shutoff member 12.

Further, a decompression mechanism 20 described later forcibly ejects air etc. from the internal space of the die assembly into the external space by suction. Thus, the space surrounded by upper-die-side ambient air shutoff member 11 and lower-die-side ambient air shutoff member 12 as well as upper-die-side mount base board 15 and lower-die-side mount base board 16 is shut off from the ambient air. Consequently, the space formed by upper die 1 and lower die 2 defines an ambient air shutoff space 10.

Apparatus 100 is further provided with decompression mechanism 20 such as a vacuum pump forcibly ejecting air etc. remaining in ambient air shutoff space 10 by suction. Decompression mechanism 20 and ambient air shutoff space 10 communicate with each other through a vacuum path 21 such as a vacuum hose. A plurality of exhaust ports are provided on the molding surface of upper die 1 although the same are not illustrated, to form a first end of vacuum path 21 respectively.

Therefore, resin-sealing and molding of electronic components provided on various substrates including a lead frame set on either one of the molding surface of upper die 1 and the molding surface of lower die 2 can be excellently performed by setting the degree of vacuum in ambient air shutoff space 10 of the die assembly to a desired value with decompression mechanism 20.

An axis member 22 constituting a hinge is provided on the back surface of upper-die-side mount base board 15. Upper-die-side ambient air shutoff member 11 pivots about axis member 22 serving as the central axis. Further, upper-die-side mount base board 15 is provided with pivot limiting members 23 limiting pivot of upper-die-side ambient air shutoff member 11. Upper-die-side ambient air shutoff member 11 and upper-die-side mount base board 15 are fixed to each other through upper-die-side fixing tools 24.

Upper-die-side fixing tools 24, employed for fixing upper-die-side mount base board 15 and upper-die-side ambient air shutoff member 11 to each other, have bolts 24a. A locking portion 24 (24b) fixing the front surface of upper-die-side ambient air shutoff member 11 and the front surface of upper-die-side mount base board 15 to each other is provided on the front surface of apparatus 100.

When the aforementioned locking portion 24 (24b) and axis member 22 are employed, upper die 1 can be exchanged without dismounting upper-die-side ambient air shutoff member 11 from apparatus 100, whereby the efficiency of the operation for exchanging upper die 1 is improved.

In addition to this, upper-die-side mount base board 15 and upper-die-side ambient air shutoff member 11 can be brought into contact with each other through upper-die-side fixing tools 24, so that no clearance is formed between upper-die-side mount base board 15 and upper-die-side ambient air shutoff member 11. Therefore, airtightness of ambient air shutoff space 10 in the die assembly can be maintained. Bolts 24a serving as upper-die-side fixing tools 24 may conceivably drop toward lower die 2 to collide with the molding surface of upper die 1 when dismounted from upper-die-side mount base board 15. Thus, bolts 24a must be prevented from dropping. Therefore, upper die 1 of the resin-sealing and molding apparatus according to this embodiment is provided with prevent portions 25. Through-holes for mounting and dismounting bolts 24a are so sized as not to pass bolts 24a therethrough, in order to attain the object of prevent portions 25.

A method of mounting and dismounting upper die chaser unit 3 constituting upper die 1 along a direction perpendicular to exchange plane A is now described with reference to Figs. 3 and 4.

Upper die chaser unit 3 is exchanged in the following manner:
As shown in Fig. 3, the respective ones of the plurality of bolts 24a are unclamped, so that the respective the plurality of bolts 24a are held by the plurality of prevent portions 25. At this time, lower die 2 retreats to a position downward beyond the PL plane, in order to prevent the molding surfaces of upper die 1 and lower die 2 from coming into contact with each other.

Thereafter upper-die-side ambient air shutoff member 11 pivots about axis member 22 substantially simultaneously with release from locking portion 24, as shown in Fig. 4. At this time, the range of pivot of upper-die-side ambient air shutoff member 11 is limited by pivot limiting members 23. Thus, an opening 26 is formed between pivoting upper-die-side ambient air shutoff member 11a and upper-die-side mount base board 15.

In the aforementioned state, upper die chaser unit 3 is dismounted from an upper die base 4 through opening 26. Thereafter another new upper die chaser unit 3 is mounted on upper die base 4 through opening 26.

According to the aforementioned method, upper die chaser unit 3 can be easily and quickly exchanged.

On the other hand, the structure on the side of lower die 2 has no structure corresponding to the aforementioned hinge-type axis member 22, pivot limiting members 23 and locking portion 24. The reason for this is as follows:
When a clearance is formed between lower-die-side ambient air shutoff member 8 and lower-die-side mount base bard 16, the resin gas remaining in the die assembly is deposited in the aforementioned clearance. Thus, deterioration or damage of the sealing members such as O-rings is so prompted that the lives thereof are reduced. Therefore, it is extremely difficult to maintain the degree of vacuum in the internal space of the die assembly at the desired value. Consequently, the resin gas deposited in the aforementioned clearance must be manually cleaned. If lower-die-side ambient air shutoff member 8 and lower-die-side mount base board 16 are connected with each other through a hinge-type axis member, however, it is difficult to completely clean the contact surfaces of lower-die-side ambient air shutoff member 8 and lower-die-side mount base board 16.

Therefore, the structure on the side of lower die 2 of the resin-sealing and mounting apparatus according to this embodiment is provided with no structure corresponding to the aforementioned hinge-type axis member 22, pivot limiting members 23 and locking portion 24 (24b). According to this structure on the side of lower die 2, lower-die-side ambient air shutoff member 12 is rendered completely dismountable from lower-die-side mount base bard 16 when lower-die-side fixing tools 27 are simply dismounted from lower-die-side mount base board 16 and lower-die-side ambient air shutoff member 12. Lower-die-side mount base board 16 and lower-die-side ambient air shutoff member 12 are fixed to each other only through lower-die-side fixing tools 27 having bolts 27a.

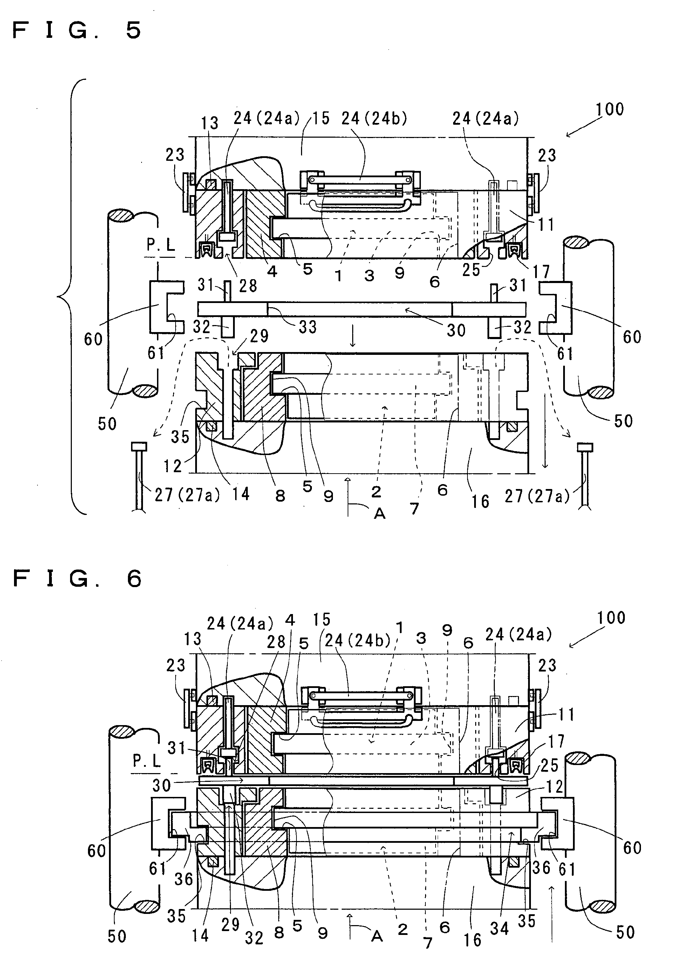

A method of mounting and dismounting lower die chaser unit 7 constituting lower die 2 along the direction perpendicular to exchange plane A is described with reference to Figs. 5 and 6.

A first die assembly exchange jig 30 shown in Figs. 5 and 6 is employed as a tool for exchanging lower die chaser unit 7. First die assembly exchange jig 30 has upper-die-side protrusions 31 inserted into upper-die-side receiving holes 28 and lower-die-side protrusions 32 inserted into lower-die-side receiving holes 29, as shown in Fig. 5. When lower die chaser unit 7 is exchanged for a new lower die chaser unit, upper-die-side fixing tools 24 fix upper-die-side mount base board 15 and upper-die-side ambient air shutoff member 11 to each other, while lower-die-side fixing tools 27 (27a) are extracted from lower-die-side receiving holes 29. First die assembly exchange jig 30 has a through portion 33 on the center thereof, in order not to damage the molding surfaces of upper die 1 and lower die 2 when coming into contact therewith.

In first die assembly exchange jig 30, the respective ones of the plurality of lower-die-side protrusions 32 are inserted into corresponding lower-die-side receiving holes 29 while the respective ones of the plurality of lower-die-side fixing tools 27 are extracted.

At this time, any one of the plurality of lower-die-side protrusions 32 is not inserted into corresponding lower-die-side receiving hole 29 if any of the plurality of lower-die-side fixing tools 27 is not dismounted from lower-die-side receiving hole 29. In other words, lower-die-side protrusions 32 have the functions of preventing first die assembly exchange jig 30 from being set on lower die 2 although not all lower-die-side fixing tools 27 corresponding to the plurality of lower-die-side receiving holes 29 are extracted therefrom.

Then, lower die 2 moves upward while the plurality of lower-die-side protrusions 32 are inserted into corresponding lower-die-side receiving holes 2. Thus, the die assembly is closed. At this time, upper-die-side protrusions 31 are inserted into upper-die-side receiving holes 28, as shown in Fig. 6. Thereafter the operation for closing the die assembly is stopped, in order not to damage the molding surfaces of upper die 1 and lower die 2.

Then, a second die assembly exchange jig 34 is prepared, as shown in Fig. 6. Second die assembly exchange jig 34 has fitting parts 36. Fitting parts 36 are inserted into the respective ones of C-shaped recesses 61 of transport rails 60 and recesses 3 5 of lower-die-side ambient air shutoff member 12 along the direction perpendicular to exchange plane A.

Upper-die-side protrusions 31 and lower-die-side protrusions 32 of first die assembly exchange jig 30 are inserted into upper-die-side receiving holes 28 and lower-die-side receiving holes 29 respectively. In order to improve relative positioning accuracy between upper die 1 and lower die 2, positioning holes (not shown) higher in precision than upper-die-side receiving holes 28 and lower-die-side receiving holes 29 may be provided on upper-die-side ambient air shutoff member 11 and lower-die-side ambient air shutoff member 12 respectively, in place of or in addition to upper-die-side receiving holes 28 and lower-die-side receiving holes 29.

Then, lower-die-side ambient air shutoff member 12 is placed on fitting parts 36 of second die assembly exchange jig 34 as shown in Fig. 6, when completely dismounted from lower-die-side mount base board 16 and lower die 2, i.e., lower die chaser unit 7 and a lower base 8. In this state, only lower-die-side mount base board 16 and lower die (lower die chaser unit 7 and lower die base 8) move downward, as shown in Fig. 7. In other words, lower-die-side ambient air shutoff member 12 is stopped by fitting parts 36 of second die assembly exchange jig 34, not to move downward. Therefore, lower-die-side sealing member 14 is exposed. This state is absolutely different from a pivoting state a conventional hinge-type axis member.

Then, lower die chaser unit 7 is extracted from lower die base 8. Thereafter another new lower die chaser unit 7 is set on lower-die-side mount base board 16, as shown in Fig. 8.

According to apparatus 100 of this embodiment, as hereinabove described, first die assembly exchange jig 30 and second die assembly exchange jig 34 are employed when lower die 2 is extracted from the apparatus. Therefore, no structure similar to axis member 22 may be employed for apparatus 100 in order to exchange lower die 2.

Similarly to the prior art, the whole die assembly may not be extracted from apparatus 100. Therefore, efficiency of the operation for cleaning the die assembly and efficiency of the operation for exchanging the die assembly are not deteriorated as compared with the prior art.

According to the resin-sealing and molding apparatus of this embodiment, as hereinabove described, the internal space of the die assembly can be prevented from reduction of airtightness also when resin-sealing and molding is repeated, while the working efficiency for exchanging the die assembly can be improved similarly to the working efficiency for exchanging the die assembly in a case of employing a conventional sealing mechanism.

It should be noted that the embodiments disclosed herein should be understood as being illustrative rather than limitative in all respects. The scope of the present invention is indicated by the appended claims rather than by the foregoing description and all changes which come within the meaning and range of equivalency of the claims are therefore intended to be embraced therein.

## Claims

1. A resin-sealing and molding apparatus with sealing mechanism, comprising:
a die assembly (1, 2) having an upper die (1) and a lower die (2) opposed to said upper die (1);
an upper-die-side mount base board (15) mounted with said upper die (1);
a lower-die-side mount base board (16) mounted with said lower die (2); and
sealing mechanism for shutting off the internal space of said die assembly (1, 2) from the ambient air, wherein
said sealing mechanism includes:
an upper-die-side ambient air shutoff member (11) so mounted on said upper-die-side mount base board (15) as to surround the lateral side of said upper die (1),
a lower-die-side ambient air shutoff member (12) so mounted on said lower-die-side mount base board (16) as to surround the lateral side of said lower die (2),
an upper-die-side fixing tool (24) fixing said upper-die-side ambient air shutoff member (11) to said upper-die-side mount base board (15),
a lower-die-side fixing tool (27) fixing said lower-die-side ambient air shutoff member (12) to said lower-die-side mount base board (16), and
an axis member (22) pivotably connecting said upper-die-side ambient air shutoff member (11) and said upper-die-side mount base board (15) with each other,
so that said lower-die-side ambient air shutoff member (12) is completely dismountable from said lower-die-side mount base board (16) by simply dismounting said lower-die-side fixing tool (27) from said lower-die-side mount base board (16) and said lower-die-side ambient air shutoff member (12).

2. The resin-sealing and molding apparatus with sealing mechanism according to claim 1, wherein
said sealing mechanism further includes a pivot limiting member (23) limiting the range of pivot of said upper-die-side ambient air shutoff member (11).

3. The resin-sealing and molding apparatus with sealing mechanism according to claim 1, wherein
said sealing mechanism further includes:
an upper-die-side sealing member (13) sealing a clearance between said upper-die-side ambient air shutoff member (11) and said upper-die-side mount base board (15),
a lower-die-side sealing member (14) sealing a clearance between said lower-die-side ambient air shutoff member (12) and said lower-die-side mount base board (16), and
an intermediate sealing member (17) sealing a clearance between said upper-die-side ambient air shutoff member (11) and said lower-die-side ambient air shutoff member (12).

4. The resin-sealing and molding apparatus with sealing mechanism according to claim 1, wherein
said sealing mechanism further includes a locking portion (24) for fixing said upper-die-side mount base board (15) and said upper-die-side ambient air shutoff member (11) to each other.

5. A method of dismounting a constituent part of a die assembly fitted in a resin-sealing and molding apparatus comprising:
a die assembly (1, 2) having an upper die (1) and a lower die (2) opposed to said upper die (1);
an upper-die-side mount base board (15) mounted with said upper die (1);
a lower-die-side mount base board (16) mounted with said lower die (2); and
sealing mechanism for shutting off the internal space of said die assembly (1, 2) from the ambient air, wherein
said sealing mechanism includes:
an upper-die-side ambient air shutoff member (11) so mounted on said upper-die-side mount base board (15) as to surround the lateral side of said upper die (1),
a lower-die-side ambient air shutoff member (12) so mounted on said lower-die-side mount base board (16) as to surround the lateral side of said lower die (2),
an upper-die-side fixing tool (24) fixing said upper-die-side ambient air shutoff member (11) to said upper-die-side mount base board (15),
a lower-die-side fixing tool (27) fixing said lower-die-side ambient air shutoff member (12) to said lower-die-side mount base board (16), and
an axis member (22) pivotably connecting said upper-die-side ambient air shutoff member (11) and said upper-die-side mount base board (15) with each other,
comprising the steps of:
dismounting said upper-die-side fixing tool (24) from said upper-die-side mount base board (16) and said upper-die-side ambient air shutoff member (11);
forming an opening (26) between said upper-die-side ambient air shutoff member (11) and said upper-die-side mount base board (15) by pivoting said upper-die-side ambient air shutoff member (11) about said axis member (22) serving as a pivot axis;
dismounting at least a part (3) of said upper die (1) from said upper-die-side mount base board (15) through said opening (26);
dismounting said lower-die-side fixing tool (27) from said lower-die-side mount base board (16) and said lower-die-side ambient air shutoff member (12);
dismounting said lower-die-side ambient air shutoff member (12) from said lower-die-side mount base board (16); and
dismounting at least a part (7) of said lower die (2) from said lower-die-side mount base board (16).

6. The method of dismounting a constituent part of a die assembly fitted in a resin-sealing and molding apparatus according to claim 5, wherein
said lower-die-side ambient air shutoff member (12) is dismounted with a jig (34) in the step of dismounting said lower-die-side ambient air shutoff member (12).

## Amended claims

### Amended claims under Art. 19.1 PCT

**1.** (amended) A resin-sealing and molding apparatus with sealing mechanism, comprising:
a die assembly (1, 2) having an upper die (1) and a lower die (2) opposed to said upper die (1);
an upper-die-side mount base board (15) mounted with said upper die (1);
a lower-die-side mount base board (16) mounted with said lower die (2); and
sealing mechanism for shutting off the internal space of said die assembly (1, 2) from the ambient air, wherein
said sealing mechanism includes:
an upper-die-side ambient air shutoff member (11) so mounted on said upper-die-side mount base board (15) as to surround the lateral side of said upper die (1),
a lower-die-side ambient air shutoff member (12) so mounted on said lower-die-side mount base board (16) as to surround the lateral side of said lower die (2),
an upper-die-side fixing tool (24) fixing said upper-die-side ambient air shutoff member (11) to said upper-die-side mount base board (15),
a lower-die-side fixing tool (27) fixing said lower-die-side ambient air shutoff member (12) to said lower-die-side mount base board (16),_
an axis member (22) pivotably connecting said upper-die-side ambient air shutoff member (11) and said upper-die-side mount base board (15) with each other, and
a lower-die-side sealing member (14) sealing a clearance between said lower-die-side ambient air shutoff member (12) and said lower-die-side mount base board (16),
so that said lower-die-side ambient air shutoff member (12) is stopped in said die assembly (1,2) and completely dismounted from said lower-die-side mount base board (16) when said lower-die-side fixing tool (27) is dismounted from said lower-die-side mount base board (16) and said lower-die-side ambient air shutoff member (12), whereby said lower-die-side sealing member (14) is exposed.

**2.** The resin-sealing and molding apparatus with sealing mechanism according to claim 1, wherein
said sealing mechanism further includes a pivot limiting member (23) limiting the range of pivot of said upper-die-side ambient air shutoff member (11).

**3.** (amended) The resin-sealing and molding apparatus with sealing mechanism according to claim 1, wherein
said sealing mechanism further includes:
an upper-die-side sealing member (13) sealing a clearance between said upper-die-side ambient air shutoff member (11) and said upper-die-side mount base board (15), and
an intermediate sealing member (17) sealing a clearance between said upper-die-side ambient air shutoff member (11) and said lower-die-side ambient air shutoff member (12).

**4.** The resin-sealing and molding apparatus with sealing mechanism according to claim 1, wherein
said sealing mechanism further includes a locking portion (24) for fixing said upper-die-side mount base board (15) and said upper-die-side ambient air shutoff member (11) to each other.

**5.** (amended) A method of dismounting a constituent part of a die assembly fitted in a resin-sealing and molding apparatus comprising:
a die assembly (1, 2) having an upper die (1) and a lower die (2) opposed to said upper die (1);
an upper-die-side mount base board (15) mounted with said upper die (1);
a lower-die-side mount base board (16) mounted with said lower die (2); and
sealing mechanism for shutting off the internal space of said die assembly (1, 2) from the ambient air, wherein
said sealing mechanism includes:
an upper-die-side ambient air shutoff member (11) so mounted on said upper-die-side mount base board (15) as to surround the lateral side of said upper die (1),
a lower-die-side ambient air shutoff member (12) so mounted on said lower-die-side mount base board (16) as to surround the lateral side of said lower die (2),
an upper-die-side fixing tool (24) fixing said upper-die-side ambient air shutoff member (11) to said upper-die-side mount base board (15),
a lower-die-side fixing tool (27) fixing said lower-die-side ambient air shutoff member (12) to said lower-die-side mount base board (16),_
an axis member (22) pivotably connecting said upper-die-side ambient air shutoff member (11) and said upper-die-side mount base board (15) with each other, and
a lower-die-side sealing member (14) sealing a clearance between said lower-die-side ambient air shutoff member (12) and said lower-die-side mount base board (16),
comprising the steps of:
dismounting said upper-die-side fixing tool (24) from said upper-die-side mount base board (16) and said upper-die-side ambient air shutoff member (11);
forming an opening (26) between said upper-die-side ambient air shutoff member (11) and said upper-die-side mount base board (15) by pivoting said upper-die-side ambient air shutoff member (11) about said axis member (22) serving as a pivot axis;
dismounting at least a part (3) of said upper die (1) from said upper-die-side mount base board (15) through said opening (26);
dismounting said lower-die-side fixing tool (27) from said lower-die-side mount base board (16) and said lower-die-side ambient air shutoff member (12);
exposing said lower-die-side sealing member (14) by stopping said lower-die-side ambient air shutoff member (12) in said die assembly (1,2) and completely dismounting said lower-die-side ambient air shutoff member (12) from said lower-die-side mount base board (16);
dismounting said lower-die-side ambient air shutoff member (12) from said lower-die-side mount base board (16); and
dismounting at least a part (7) of said lower die (2) from said lower-die-side mount base board (16).

**6.** (amended) The method of dismounting a constituent part of a die assembly fitted in a resin-sealing and molding apparatus according to claim 5, wherein
said lower-die-side ambient air shutoff member (12) is stopped with a jig (34) in the step of exposing said lower-die-side sealing member.
